# EUROPEAN PATENT APPLICATION

(11) **EP 2 574 686 A1**
(43) Date of publication of application: **03.04.2013**
(21) Application number: 12186666.9
(22) Date of filing: 28.09.2012
(51) Int. Cl.: C23C 14/06, C23C 14/32, C23C 14/00

(54) **Stainless steel and silver colored PVD coatings**

(30) Priority: 29.09.2011 US 201113248530
(71) Applicant: Vapor Technologies, Inc., Longmont CO 80503 (US)
(72) Inventor: Rice, Jeffrey, Ft. Lupton, CO 80621 (US); Anton, Bryce, Longmont, CO 80501 (US)
(74) Representative: Croston, David

(57) **Abstract**

A method of making a coated substrate comprises depositing a base layer onto a substrate to form a first coated substrate. A chromium nitride layer is then deposited onto the first coated substrate to form a second coated substrate. The chromium nitride has an atomic percent of nitrogen less that about 45 atom percent.

## Description

### FIELD OF THE INVENTION

In at least one aspect, the present invention relates to coated substrates having a silver or stainless steel appearance.

### BACKGROUND OF THE INVENTION

Metallization of metallic parts for cosmetic use is typically done utilizing various wet chemistry techniques. Examples of applications include bathroom applications (e.g., faucets), automotive applications, and the like. One particularly useful coating process for these applications involves the application of chrome to the substrate surface.

A prior art chrome plating process begins with cleaning and rinsing of the substrate. In the typical process, the substrate is immersed in the chrome plating bath with the subsequent application of a current to commence the coating process. In this regard, processes using both trivalent chromium and hexavalent chromium are known. Trivalent chromium and hexavalent chromium plating methodologies are undesirable since such processes are messy, costly, and heavily regulated.

Accordingly, there exists a need for improved methods of coating metal substrates that do not utilize trivalent or hexavalent chromium.

### SUMMARY OF THE INVENTION

In at least one embodiment, the present invention solves one or more problems of the prior art by providing a method of making a colored coated substrate. The method includes a step of providing a substrate to be coated. A base layer is then deposited onto the substrate to form a first coated substrate. A chromium nitride layer is next deposited onto the first coated substrate to form the colored coated substrate. Characteristically, the chromium nitride layer has an atomic percent of nitrogen less that about 45 atom percent.

In another embodiment, a method of making a colored coated substrate in a cathodic arc deposition system is provided. Characteristically, the cathode arc deposition system includes a metallic chromium-containing target positioned in a deposition chamber, and at least one substrate positioned in the deposition chamber. The method includes introducing an inert gas into the deposition chamber and then initiating an arc in the deposition chamber such that chromium is removed from the metallic chromium-containing target. The metal is deposited onto the substrate thereby forming a chromium base layer on the substrate. Nitrogen gas is introduced into the deposition chamber such that chromium nitride is deposited onto the base layer to form the colored coated substrate. The chromium nitride has an atomic percent of nitrogen less than about 45 atom percent.

### BRIEF DESCRIPTION OF THE DRAWINGS

FIGURE 1 provides a schematic flow chart illustrating a method of making a color coated substrate; and

FIGURE 2 is a schematic illustration of a cathodic arc coating apparatus for coating substrates.

### DESCRIPTION OF THE INVENTION

Reference will now be made in detail to presently preferred compositions, embodiments and methods of the present invention, which constitute the best modes of practicing the invention presently known to the inventors. The Figures are not necessarily to scale. However, it is to be understood that the disclosed embodiments are merely exemplary of the invention that may be embodied in various and alternative forms. Therefore, specific details disclosed herein are not to be interpreted as limiting, but merely as a representative basis for any aspect of the invention and/or as a representative basis for teaching one skilled in the art to variously employ the present invention.

Except in the examples, or where otherwise expressly indicated, all numerical quantities in this description indicating amounts of material or conditions of reaction and/or use are to be understood as modified by the word "about" in describing the broadest scope of the invention. Practice within the numerical limits stated is generally preferred. Also, unless expressly stated to the contrary: percent, "parts of," and ratio values are by weight; the description of a group or class of materials as suitable or preferred for a given purpose in connection with the invention implies that mixtures of any two or more of the members of the group or class are equally suitable or preferred; description of constituents in chemical terms refers to the constituents at the time of addition to any combination specified in the description, and does not necessarily preclude chemical interactions among the constituents of a mixture once mixed; the first definition of an acronym or other abbreviation applies to all subsequent uses herein of the same abbreviation and applies mutatis mutandis to normal grammatical variations of the initially defined abbreviation; and, unless expressly stated to the contrary, measurement of a property is determined by the same technique as previously or later referenced for the same property.

It is also to be understood that this invention is not limited to the specific embodiments and methods described below, as specific components and/or conditions may, of course, vary. Furthermore, the terminology used herein is used only for the purpose of describing particular embodiments of the present invention and is not intended to be limiting in any way.

It must also be noted that, as used in the specification and the appended claims, the singular form "a," "an," and "the" comprise plural referents unless the context clearly indicates otherwise. For example, reference to a component in the singular is intended to comprise a plurality of components.

In various embodiments of the present invention, physical vapor deposition (PVD) is used to create a stainless steel color or a silver color on a substrate. Such color coated substrates are used for both decorative and corrosion resisting applications, examples of which include, but are not limited to, plumbing components (e.g., faucets, knobs for faucets, and the like), automotive components, consumer electronics (e.g. cell phones) and consumer products (e.g., watches). The stainless steel color is achieved adding a controlled amount of nitrogen to chromium to make chromium nitride. The silver color is achieved by adding very small amounts of nitrogen to chromium during the PVD deposition to simulate the silver color. These coatings are preferably applied to electroplated nickel rather than the typically used hexavalent chromium.

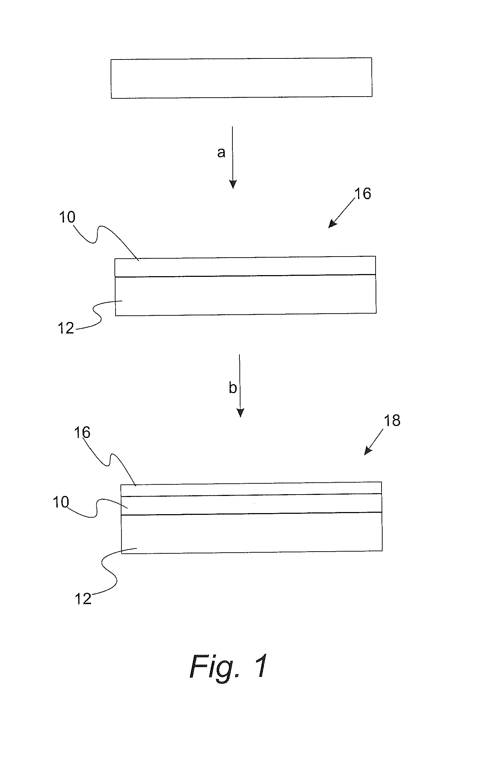

With reference to Figure 1, a schematic flowchart depicting a method of making a coated substrate is provided. In step a), base layer 10 is deposited onto the substrate 12 to form first coated substrate 14. Examples of suitable base layers include, but are not limited to, chromium, nickel, stainless steel, aluminum and anodized aluminum Finally, in step b), chromium nitride 16 is deposited onto first coated substrate 14 to form coated substrate 20. Characteristically, chromium nitride layer 16 has an atomic percent of nitrogen less than about 45 atom percent.

In a variation of the present embodiment, the base layer and the chromium nitride are deposited by physical vapor deposition. Examples of useful deposition processes include, but are not limited to, cathodic arc deposition, evaporation, sputtering, and the like. Cathodic arc deposition is found to be particularly useful for practicing the method of the present embodiment.

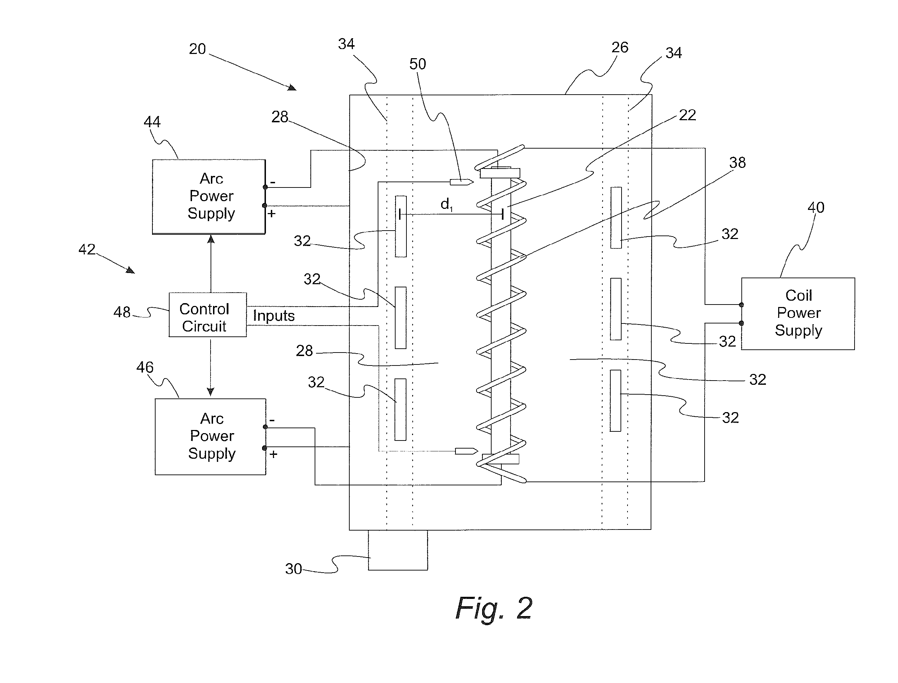

Figure 2 is a schematic of an arc deposition system used to deposit the color coated substrates of the present invention. During operation of the arc deposition system 20, an arc is struck which causes significant ionization of gas (e.g., argon, helium, etc.) and cathode atoms thereby forming a plasma. The ionized metal cathode ions are directed from the region of the cathode towards the substrates which are coated with a metal layer or nitride layer as set forth above. Arc deposition system 20 includes cathode target 22 which is placed within vacuum chamber 26. A chromium target is used in various embodiments of the present invention. Arc deposition system 20 includes at least one anode. In a refinement, wall 28 of vacuum chamber 26 is an anode. Characteristically, cathode target 22 is of an elongated design (e.g., cylindrical or rod-shaped). It should also be appreciated that the cross section of target 22 may be of virtually any shape, examples of which include, but are not limit to circular, triangular, square, pentagonal, hexagonal, elliptical or irregularly shaped. Arc deposition system 20 is maintained at a reduced pressure during coating of a substrate via suitable vacuum systems as is known in the field via port 30. Typically, operating pressures are between 0.5 and 50 mT. In accordance with an embodiment of the present invention, a chromium base layer is first formed from cathode target 22 by introducing an inert gas (e.g., argon) into vacuum chamber 26. Nitrogen gas is then introduced in order to form the chromium nitride layer from cathode target 22.

Substrates 32 are positioned within substrate zone 34 that is a distance d₁ from cathode target 22. In a refinement, system 20 includes helical electromagnet coil 38 which is coaxially mounted about cathode target 22. Helical electromagnet coil 38 is powered by a separate coil power supply 40. Electromagnet coil 38 may be electrically isolated or it may be connected to the vacuum chamber 26.

Control system 42 is provided to vary the current input to each end of the cathode target 22 while maintaining the total arc current substantially constant, such that the current to each end of cathode target 22 may be varied between 0 and 100 percent of the total arc current supplied. Arc current is directly correlated to deposition rate and can be controlled between 50A and, for example, 2000 A, the upper limit determined by cooling efficiency of the target. This may be accomplished by using separate arc power supplies 44, 46 connected at each end of cathode target 22 with a controller 48 to provide complementary set point signals for the separate arc power supplies 44, 46. In an alternative variation, a single arc power supply having two complementary current outputs may be employed. Arc initiator 50 is used to strike the arc.

Still referring to Figure 2, the arc tends to be drawn toward whichever end of the cathode target 22 is receiving the larger fraction of the total current input, due to the self magnetic field of the arc current in the cathode target. The speed at which the arc moves in one direction along the cathode target 22 is partly determined by the degree of imbalance between the currents flowing into each end of cathode target 22. The arc spot can, therefore, be scanned back and forth along the cathode target 22 by varying the division of current between the two ends of cathode target 22 in an oscillatory fashion. Cathode target 22 can, therefore, be uniformly eroded, and the arc can be maintained continuously on the cathode surface rather than being repeatedly restruck as taught by the prior art. A sensor may be conveniently located at each of the ends of the evaporable surface of cathode target 12 to provide a signal when the arc spot reaches one end of the evaporable surface of cathode target 22, at which time the current division may be reversed, allowing automated scanning of the arc spot along the entire surface of cathode target 22.

Electromagnet coil 38 may be connected in series with the arc power supply 44, 46, such that the arc current flows through electromagnet coil 38 to generate an axial magnetic field. Since the coil is connected between the positive output of arc power supply 44, 46 and the anode, and since the total arc current is constant, the current input to the electromagnet coil 38 is not affected by the variation in current to the two ends of cathode target 22. This arrangement eliminates the necessity of a separate power supply for powering electromagnet coil 38, but sacrifices independent adjustability of the strength of the applied magnetic field except through selection of the pitch of electromagnet coil 38.

In a variation of the present embodiment, coated substrate is characterized by having a silver color with Lab color space coordinates of L* = 85.3 (± 2.0), a* = -0.10 (±0.50), and b* = 0.20 (± 1.0). Typically, the atomic percent of nitrogen in the chromium nitride layer is from about 3 to 8 percent. In a refinement, the atomic percent of nitrogen in the chromium nitride layer is from about 2 to 7 percent. Moreover, the chromium nitride layer typically has a thickness from about 0.05 to 0.15 microns.

In another variation, the coated substrate has a stainless steel color having Lab color space coordinates of L* = 75.0 (± 3.0), a* = 0.50 (± 0.50), and b* = 1.80 (±1.0). In this variation, the atomic percent of nitrogen is from about 30 to 45 percent. In a refinement of this variation, the atomic percent of nitrogen is from about 32 to 43 percent. In another refinement of this variation, the chromium nitride layer has a thickness from about 0.05 to 0.15 microns.

In yet another variation, the base layer comprises chromium or nickel. In one refinement of this variation, the base layer has a thickness from about 0.05 to 0.5 microns.

The following examples illustrate the various embodiments of the present invention. Those skilled in the art will recognize many variations that are within the spirit of the present invention and scope of the claims.

### EXAMPLE I

Stainless steel watch cases are polished, textured to a matte finish by a grit-blasting process and cleaned by known methods. The textured watch cases are placed in a cathodic arc evaporation plating vessel. The vessel is generally a cylindrical enclosure containing a vacuum chamber which is adapted to be evacuated by means of pumps. Sources of argon and nitrogen gases are connected to the chamber by adjustable valves for varying the rate of flow of argon and nitrogen into the chamber.

A cylindrical cathode is mounted in the center of the chamber and connected to negative outputs of a variable D.C. power supply. The positive side of the power supply is connected to the chamber wall. The cathode material comprises chromium.

The cases are mounted on spindles which are mounted on a ring around the outside of the cathode. The entire ring rotates around the cathode while each spindle also rotates around its own axis, resulting in a so-called planetary motion which provides uniform exposure to the cathode for the multiple parts mounted around each spindle. The ring typically rotates at several rpm, while each spindle makes several revolutions per ring revolution. The spindles are electrically isolated from the chamber and provided with rotatable contacts so that a bias voltage may be applied to the substrates during coating. The vacuum chamber is evacuated to a pressure of about 10⁻⁵ to 10⁻⁷ Torr and heated to about 150°C.

The watch cases are then subjected to a high-bias arc plasma cleaning in which a (negative) bias voltage of about -600 volts is applied to the parts while an arc of approximately 500 amperes is struck and sustained on the cathode. The duration of the cleaning is approximately five minutes.

Argon gas is introduced at a rate sufficient to maintain a pressure of about 1 to 5 millitorr. A layer of chromium having an average thickness of about 0.10 µm is deposited on the watch cases during a three minute period. The cathodic arc deposition process comprises applying D.C. power to the cathode to achieve a current flow of about 500 amps, introducing argon gas into the vessel to maintain the pressure in the vessel at about 1 to 5 millitorr, a substrate bias of -50 volts and rotating the parts in a planetary fashion described above.

After the chromium layer is deposited, a chromium nitride base layer is deposited on the chromium layer. A flow of nitrogen is introduced into the vacuum chamber while the arc discharge continues at approximately 500 amperes and a substrate bias of -50 volts. In order to modify the hardness of the coating, the nitrogen is present in an amount of 50 to 75 percent of the total gas flow. The thickness of this base layer is between 0.20 and 0.50 µm. The flow of nitrogen is then significantly reduced to approximately 2 to 3 percent of total flow to deposit a final color layer of CrNx where x = 0.5 to 0.15. The thickness of this final layer is between 0.05 and 0.15µm. The arc is extinguished, the vacuum chamber is vented and the coated articles removed. The resulting color of the coating is : L* = 85.3 (± 2.0), a* = -0.10 (±0.50), and b* = 0.20 (± 1.0). (CIELAB, D65, 10° observer), which has the white metallic appearance of silver or aluminum.

### EXAMPLE II

Brass faucets are placed in a conventional soak cleaner bath containing the standard and well known soaps, detergents, defloculants and the like which is maintained at a pH of 8.9-9.2 and a temperature of 180-200°F for about 10 minutes. The brass faucets are then placed in a conventional ultrasonic alkaline cleaner bath. The ultrasonic cleaner bath has a pH of 8.9-9.2, is maintained at a temperature of about 160-180°F, and contains the conventional and well known soaps, detergents, defloculants and the like. After the ultrasonic cleaning, the faucets are rinsed and placed in a conventional alkaline electro cleaner bath.

The electro cleaner bath is maintained at a temperature of about 140-180°F, a pH of about 10.5-11.5, and contains standard and conventional detergents. The faucets are then rinsed twice and placed in a conventional acid activator bath. The acid activator bath has a pH of about 2.0-3.0, is at an ambient temperature, and contains a sodium fluoride based acid salt. The faucets are then rinsed twice and placed in a bright nickel plating bath for about 12 minutes. The bright nickel bath is generally a conventional bath which is maintained at a temperature of about 130-150°F, a pH of about 4.0, contains NiSO₄, NiCl₂, boric acid, and brighteners. A bright nickel layer of an average thickness of about 10 µm is deposited on the faucet surface. The nickel plated faucets are then textured using an abrasive buffmg wheel to impart a directional brushed texture on all surfaces. The vacuum chamber is evacuated to a pressure of about 10⁻⁵ to 10⁻⁷ Torr and heated to about 150°C.

The electroplated faucets are then subjected to a high-bias arc plasma cleaning in which a (negative) bias voltage of about -600 volts is applied to the electroplated faucets while an arc of approximately 500 amperes is struck and sustained on the cathode. The duration of the cleaning is approximately five minutes.

Argon gas is introduced at a rate sufficient to maintain a pressure of about 1 to 5 millitorr. A layer of chromium having an average thickness of about 0.20 µm is deposited on the nickel plated faucets during a three minute period. The cathodic arc deposition process comprises applying D.C. power to the cathode to achieve a current flow of about 500 amps, introducing argon gas into the vessel to maintain the pressure in the vessel at about 1 to 5 millitorr, a substrate bias of -50 volts and rotating the faucets in a planetary fashion described above.

After the chromium layer is deposited, a chromium nitride color layer is deposited on the chromium layer. A flow of nitrogen is introduced into the vacuum chamber while the arc discharge continues at approximately 500 amperes and a substrate bias of -50 volts. In order to modify the color of the coating, the nitrogen is present in an amount of 50 to 75 percent of the total gas flow. The thickness of this color layer is between 0.10 and 0.25 µm. The arc is extinguished, the vacuum chamber is vented and the coated articles removed. The resulting color of the coating is: L* = 75.0 (± 3.0), a* = 0.50 (± 0.50), and b* = 1.80 (±1.0) (CIELAB, D65, 10° observer), which has the appearance of stainless steel.

While embodiments of the invention have been illustrated and described, it is not intended that these embodiments illustrate and describe all possible forms of the invention. Rather, the words used in the specification are words of description rather than limitation, and it is understood that various changes may be made without departing from the spirit and scope of the invention.

## Claims

1. A method of coating a substrate to form a colored coated substrate, the method comprising:
a) depositing a base layer onto the substrate to form a first coated substrate; and
b) depositing a chromium nitride layer onto the first coated substrate to form the colored coated substrate, the chromium nitride layer having an atomic percent of nitrogen less that about 45 atom percent, wherein the base layer and the chromium nitride layer are deposited by physical vapor deposition.

2. The method of claim 1 comprising the use of a cathodic arc deposition system, the cathode arc deposition system including a metallic chromium-containing target positioned in a deposition chamber, and at least one substrate positioned in the deposition chamber, the method comprising:
a) introducing an inert gas into the deposition chamber;
b) initiating an arc in the deposition chamber such that chromium is removed from the metallic chromium-containing target and deposited onto the substrate thereby forming a chromium base layer on the substrate; and
c) introducing nitrogen gas into the deposition chamber such that a chromium nitride layer is deposited onto the base layer to form the colored coated substrate, the chromium nitride layer having an atomic percent of nitrogen less than about 45 atom percent.

3. The method of claim 1 or claim 2 wherein the colored coated substrate has a silver color with Lab color space coordinates of L* = 85.3 (± 2.0), a* = -0.10 (±0.50), and b* = 0.20 (± 1.0) or has a stainless steel color having Lab color space coordinates of L* = 75.0 (± 3.0), a* = 0.50 (± 0.50), and b* = 1.80 (±1.0).

4. The method of claim 3 wherein the colored coated substrate has a silver color and wherein the atomic percent of nitrogen in the chromium nitride layer is from about 3 to 8 percent, preferably
from about 2 to 7 percent.

5. The method of claim 3 wherein the colored coated substrate has a silver color and wherein the chromium nitride layer has a thickness from about 0.05 to 0.15 microns.

6. The method of claim 3 wherein the colored coated substrate has a stainless steel color and wherein the atomic percent of nitrogen in the chromium nitride layer is from about 30 to 45 percent, preferably
from about 32 to 43 percent.

7. The method of claim 3 wherein the colored coated substrate has a stainless steel color and wherein the chromium nitride layer has a thickness from about 0.10 and 0.25 microns.

8. The method of claim 1 wherein the base layer comprises chromium, nickel, stainless steel, aluminum or anodized aluminum.

9. The method of claim 1 wherein the base layer has a thickness from about 0.05 to 0.5 microns.

10. A colored coated substrate comprising:
a substrate;
a chromium base layer disposed over the substrate; and
a chromium nitride layer disposed over the base layer, the chromium nitride layer having an atomic percent of nitrogen less that about 45 atom percent.

11. The colored coated substrate of claim 10 wherein the colored coated substrate has a silver color with Lab color space coordinates of L* = 85.3 (± 2.0), a* = -0.10 (±0.50), and b* = 0.20 (± 1.0) or has a stainless steel color having Lab color space coordinates of L* = 75.0 (± 3.0), a* = 0.50 (± 0.50), and b* = 1.80 (±1.0).

12. The colored coated substrate of claim 11 wherein the colored coated substrate has a silver color, and wherein the atomic percent of nitrogen in the chromium nitride layer is from about 3 to 8 percent.

13. The colored coated substrate of claim 12 wherein the colored coated substrate has a silver color, and wherein the chromium nitride layer has a thickness from about 0.05 to 0.15 microns.

14. The colored coated substrate of claim 11 wherein the colored coated substrate has a stainless steel color, and wherein the atomic percent of nitrogen in the chromium nitride layer is from about 30 to 45 percent.

15. The colored coated substrate of claim 11 wherein the colored coated substrate has a stainless steel color, and wherein the chromium nitride layer has a thickness from about 0.1 to 0.25 microns.
